# DEMANDE DE BREVET EUROPEEN

(11) **EP 1 936 954 A2**
(43) Date de publication de la demande: **25.06.2008**
(21) Numéro de dépôt: 07380347.0
(22) Date de dépôt: 11.12.2007
(51) Int. Cl.: H04N 5/14

(54) **Système pour traiter les signaux de tv terrestre**

(30) Priorité: 22.12.2006 ES 200603246
(71) Demandeur: Angel Iglesias S.A., 20009 San Sebastian (ES)
(72) Inventeur: Alvarez Pelaez, Isidoro, 20009 San Sebastian (Gipuzkoa) (ES); Dominguez Bonini, Marco, 20009 San Sebastian (Gipuzkoa) (ES)
(74) Mandataire: Urizar Barandiaran, Miguel Angel

(57) **Abrégé**

Système pour traiter les signaux de TV terrestre qui est muni d'un bloc convertisseur descendant (5) où sont incluent deux mélangeurs (10) dont les sorties sur deux bandes base 1 et Q déphasées de 90° l'une de l'autre sont envoyées à un bloc sélectionneur (6) de largeur de bande dont les sorties sont envoyées à n bloc convertisseur ascendant (8) qui comprend deux mélangeurs (11) et un oscillateur (7) contrôleur par PLL dont les deux sorties sont déphasées de 90° l'une de l'autre, l'une correspondant à la bande base 1, fonction de cos ωt. et l'autre corespondant à la bande base Q, fonction de sin ωt, envoyant leurs sorties aux mélangeurs (10), (11) du bloc convertisseur descendant (5) et du bloc convertisseur ascendant (8).

## Description

Nous connaissons déjà le traitement des signaux de TV terrestre analogique ou numérique au moyen de stations de tête ou de centrales qui se basent sur trois systèmes :
1.- Systèmes avec filtrages directs en RF (radio fréquence porteuse de la modulation ou du contenu du canal) au moyen de filtres préréglés.
   Ces systèmes sont peu sélectifs ou difficiles à obtenir, exigeant des réglages critiques sur la chaîne d'acquisition pour les différents canaux à utiliser, étant réalisés parfois sur demande ou avec l'alimentation de plusieurs canaux possibles.
2.- Systèmes de filtres d'entraînement.
   L'utilisation de filtres d'entraînement apporte une solution à la sélection du canal ou groupe de canaux mais aux prix d'une plus grande complexité de circuits et d'une sélectivité amoindrie, ayant besoin d'une caractérisation spécifique dans la chaîne d'acquisition par filtre fabriqué, ladite caractérisation étant sauvegardée dans la mémoire interne du module.
   Ces procédés sont onéreux et ne donnent pas de résultats satisfaisants quant aux problèmes et aux besoins changeants du traitement des signaux de la télévision terrestre.
3.- Systèmes basés sur des techniques de passage par Fl (fréquence intermédiaire), sur des fréquences plus ou moins hautes qui. permettent l'usage de filtres FOS (filtres à ondes superficielles), à largeur fixe et adaptée à l'information à traiter.

Ceci résout certains problèmes de filtrage en RF dans le sens où il évite les réglages compliqués de la chaîne d'acquisition, il résout le problème de la sélectivité pour un canal et la rapidité de sélection de n'importe quel canal à traiter mais avec une complexité accrue et des coûts de circuits qui impliquent parfois le passage par deux FI différentes et jusqu'à quatre filtres FOS, avec un coût très souvent prohibitif. II faut ajouter d'autre part que le passage par ces FI ne permet pas d'éviter non plus l'utilisation de filtres d'entraînement en RF qui, malgré une sélectivité amoindrie, doivent être définis dans la chaîne d'acquisition.

Le sollicitant considère que les problèmes rencontrés actuellement avec l'application des systèmes mentionnés proviennent du besoin inhérent d'utiliser des filtrages compliqués du canal en RF ou de filtres FOS.

La solution du sollicitant à ces problèmes est un processeur qui comme passage intermédiaire convertit le signal d'entrée en fréquence intermédiaire zéro (FI zéro).

La conversion par le passage de Fl zéro transfère l'information contenue dans le canal de RF au moyen d'une conversion (FI) sur la bande base ou l'information contenue dans le canal de manière à obtenir une bande base appelée I en phase et une autre Q en quadrature.

La bande base étant située sur un spectre, avec des fréquences très souples à l'aide de filtres simples passe-bas construits avec des bobines et des condensateurs conventionnels (pas de filtres FOS) ou filtrage numérique, pouvant sélectionner différents filtres fixes ou être variable et s'adapter à la largeur d'un canal ou d'un groupe de canaux à traiter. Comme il s'agit de filtres passe-bas à fréquences fixes ou à faible variation de largeur, il n'est pas nécessaire de réaliser une grande caractérisation de ces derniers sur la chaîne d'acquisition.

À l'aide de la bande base I et Q traitée, il faut une conversion simple vers le haut sans filtres d'entraînement complexes de ces deux signaux combinés pour obtenir le canal sélectionné de sortie ou du groupe de canaux.

Concrètement, le système que recommande la présente invention pour traiter les signaux de télévision terrestre se caractérise par le fait que le signal TV RF est atténué au niveau exigé grâce à un amplificateur d'entrée, puis envoyé à un bloc de conversion qui est muni des éléments suivants :
a) un bloc de conversion où est inclus un amplificateur avec une sortie sur deux branches qui sont envoyés à deux mélangeurs dont les sorties sur deux bandes base I et Q sont déphasées de 90° l'une de l'autre et envoyées à
b) un bloc de sélection de largeur de bande au moyen de deux filtres passe-bas dont les sorties sont envoyées à
c) un bloc de conversion ascendant qui est muni de deux mélangeurs dont les sorties sont ajoutées par un additionneur et amplifiées par un amplificateur, avec une sortie (SRF2) qui constitue la sortie RF traitée pour le canal choisi,
d) un oscillateur de contrôle par PLL dont les deux sorties sont déphasées de 90° l'une de l'autre, l'une correspondant à la bande base I, une fonction de cos ωt. et l'autre correspondant à la bande base Q, une fonction de sin ωt, envoyant ses sorties respectivement aux mélangeurs du bloc de conversion descendant et du bloc de conversion ascendant.

Elle est caractérisée également par le fait qu'elle est munie d'un bloc additionneur doté de moyens pour recueillir tous les canaux traités et les acheminer vers une seule sortie.

Elle est caractérisée également par le fait que le filtrage sur la bande base peut être conventionnel ou complexe, ce dernier permettant de réaliser l'égalisation ou la correction dans le canal.

Le passage par FI zéro résout le problème de la sélectivité sans avoir à recourir aux filtres FOS de largeur fixe ; il évite des réglages compliqués sur la chaîne d'acquisition des filtres d'entraînement. Les filtres RF hautement sélectifs et difficiles à régler ne sont pas nécessaires. La complexité des circuits est réduite par rapport au passage de Fl par FOS. Le processeur est ainsi plus simple, moins coûteux et N processeurs peuvent être disposés sur un même équipement/système, apportant une bonne solution au traitement des signaux de télévision terrestre.

Pour mieux comprendre l'objet de la présente invention, une forme choisie de réalisation pratique a été représentée sur les plans, susceptible de changements accessoires qui ne modifieront pas son fondement.

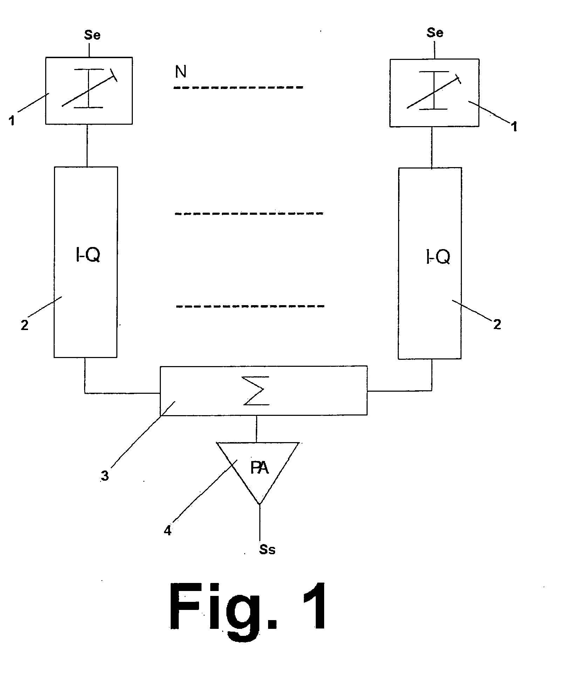

La figure 1 est un diagramme du processeur, objet de présente invention.

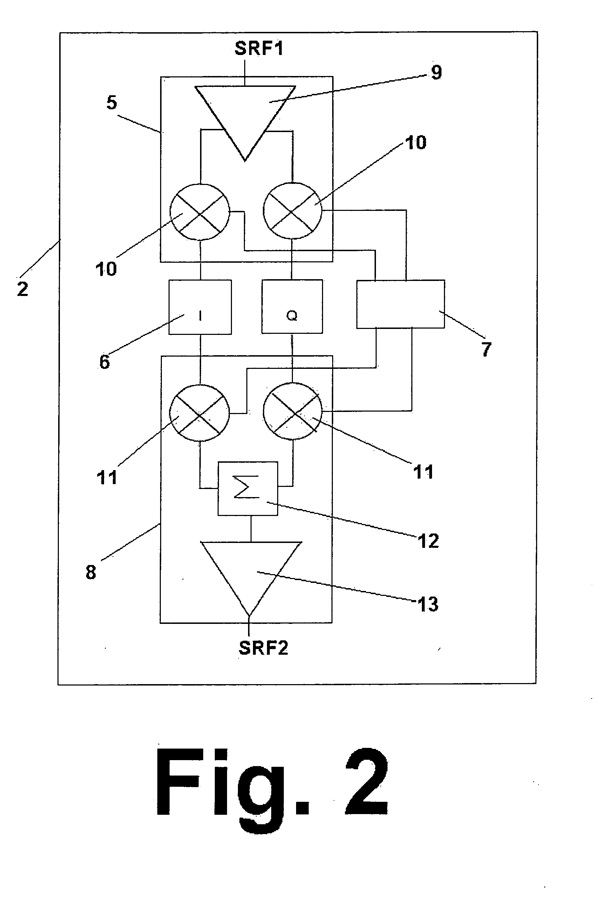

La figure 2 est un diagramme du bloc de conversion descendant et ascendant (2).

Un exemple de réalisation pratique non limitatif de la présente invention est décrit ci-dessous.

Le signal d'entrée (Se) de TV terrestre est envoyé à N blocs amplificateurs (1) afin d'atténuer l'entrée (de manière électrique ou mécanique) et d'adapter les niveaux de RF à ceux exigés par un amplificateur d'entrée, en évitant des saturations sur le bloc (2) et permettant la génération des deux signaux I et Q sur ce bloc (2).

Bloc de conversion (2) qui comprend le convertisseur descendant de RF/FI zéro ou la bande base du canal ou groupe de canaux sélectionnés. C'est sur ce bloc (2) que seront produits les signaux I et Q pour leur filtrage postérieur numérique ou à l'aide de filtres conventionnels et une conversion vers le haut où I et Q seront combinés pour obtenir le canal sélectionné de sortie ou groupe de canaux (blocs 5, 6, 7 et 8).

Bloc additionneur (3) destiné à recueillir tous les canaux traités avec un signal utile de TV terrestre mais à un niveau encore bas et à les acheminer vers une seule sortie.

Bloc d'amplification de puissance (4) qui reçoit tous les canaux, muni d'un contrôle de niveau, manuel ou automatique pour adapter le signal de sortie (Ss) aux besoins du réseau de distribution.

Le bloc principal est le bloc convertisseur (2) qui est muni des blocs (5), (6), (7), (8).

Le signal d'entrée (SRFI) est de RF à traiter et il provient du bloc (1).

Le bloc (5) est un convertisseur descendant qui est muni d'un amplificateur' (9) qui envoie sa sortie par deux branches aux deux égalisateurs (10) qui disposent d'entrées provenant du bloc (7) et dont les sorties déphasées de 90°C l'une de l'autre sont envoyées au bloc (6).

Ce bloc (5) convertisseur transfère l'information contenue dans le canal de RF par conversion (FI) à la bande base ou l'information contenue dans le canal de manière à obtenir deux bandes bases appelées I et Q en quadrature, pour le filtrage postérieur de l'information à traiter.

Le bloc (6) sélectionne la largeur de bande à traiter au moyen de deux filtres (6I), (6Q) passe-bas (LPF), pouvant être de traitement numérique ou conventionnel au moyen de bobines et de condensateurs : ils peuvent être par exemple d'une fréquence de coupe laissant passer un canal de 8 MHz. Ce filtrage pourra être conventionnel (filtres passe-bas identiques) ou complexes permettant l'égalisation ou la correction du canal, le cas échéant.

Le bloc (7) est un oscillateur local contrôlé par PLL (Phase Locked Loop) qui permet au système d'avoir une souplesse de programmation de canal d'entrée et de sortie, obtenant de l'oscillateur deux sorties en quadrature, I étant une fonction de cos ωt. et Q une fonction sin ωt., en les envoyant aux deux mélangeurs contenus dans les blocs (5) et (8).

Les signaux provenant du bloc de sélection (6) sont envoyés à un bloc (8) qui est un convertisseur ascendant qui est muni de deux mélangeurs (11), un additionneur (12) et un amplificateur (13) de sorte que l'information contenue dans la bande base est transférée au moyen d'une conversion de chaque signal I et Q au canal de RF sélectionné. Ce canal filtré et égalisé par rapport aux autres canaux de l'installation est prêt à être amplifié aux niveaux de fonctionnement du réseau de distribution après passage par les blocs (3) et (4) mentionnés antérieurement.

## Revendications

1. Système pour traiter les signaux de TV terrestre, **caractérisé par le fait que** le signal de TV RF est atténué au niveau exigé grâce à un amplificateur d'entrée puis envoyé à un bloc convertisseur (2) qui est muni des éléments suivants:
a) un bloc convertisseur descendant (5) qui est muni d'un amplificateur (9) avec sortie dans deux branches envoyées aux deux égalisateurs (10) dont les sorties sur deux bandes base I et Q déphasées de 90°C l'une de l'autre sont envoyées
b) au bloc sélectionneur (6) de largeur de bande au moyen de deux filtres passe-bas dont les sorties sont envoyées à
c) un bloc convertisseur ascendant (8) qui est muni de deux mélangeurs (11) dont les sorties sont ajoutées par un additionneur (12) et amplifiées par un amplificateur (13) et dont la sortie (SRF2) constitue la sortie de RF traité du canal choisi,
d) un oscillateur (7) contrôleur par PLL dont les deux sorties sont déphasées de 90° l'une de l'autre, l'une correspondant à la bande base I, une fonction de cos ωt. et l'autre correspondant à la base base Q, une fonction de sin ωt, envoyant ses sorties aux mélangeurs (10), (11) du bloc convertisseur descendant (5) et du bloc convertisseur ascendant (8).

2. Système pour traiter les signaux de TV terrestre selon la revendication précédente **caractérisée par le fait qu'**il est muni d'un bloc additionneur (3) doté de moyens pour recueillir tous les canaux traités et les acheminer vers une seule sortie.

3. Système pour traiter les signaux de TV terrestre, selon la revendication 1, **caractérisé par le fait que** le filtrage sur la bande base peut être conventionnel ou complexe, ce dernier permettant de réaliser l'égalisation ou la correction dans le canal.
